Europäisches Patentamt

European Patent Office

Office européen des brevets

(11) Veröffentlichungsnummer: **0 483 149 B1**

(19)

(12) **EUROPÄISCHE PATENTSCHRIFT**

(45) Veröffentlichungstag der Patentschrift: **12.10.94**

(51) Int. Cl.5: **F02P 3/055**

(21) Anmeldenummer: **90904608.8**

(22) Anmeldetag: **22.03.90**

(86) Internationale Anmeldenummer:
**PCT/DE90/00227**

(87) Internationale Veröffentlichungsnummer:
**WO 91/01447 (07.02.91 91/04)**

(54) **ÜBERWACHUNGSEINRICHTUNG FÜR EINE ZÜNDUNGSENDSTUFE AN EINER BRENNKRAFTMASCHINE.**

(30) Priorität: **20.07.89 DE 3924129**

(43) Veröffentlichungstag der Anmeldung:
**06.05.92 Patentblatt 92/19**

(45) Bekanntmachung des Hinweises auf die Patenterteilung:
**12.10.94 Patentblatt 94/41**

(84) Benannte Vertragsstaaten:
**DE FR**

(56) Entgegenhaltungen:
**DE-A- 2 842 923**
**FR-A- 2 376 953**
**US-A- 4 020 816**
**US-A- 4 303 977**

**PATENT ABSTRACTS OF JAPAN, vol. 10, No. 51, (M-457) (2108), 28 February 1986 ; & JP-A-60 201 075**

(73) Patentinhaber: **ROBERT BOSCH GMBH**
**Postfach 30 02 20**
**D-70442 Stuttgart (DE)**

(72) Erfinder: **KRAUTER, Immanuel**
**Hauptstrasse 26**
**D-7151 Erbstetten (DE)**
Erfinder: **KLOETZNER, Winfried**
**Hauptstrasse 8**
**D-7133 Maulbronn-Schmie (DE)**
Erfinder: **MÖSSNER, Claus**
**Hoehenstrasse 8**
**D-7531 Eisingen (DE)**
Erfinder: **WEIDNER, Andreas**
**Ganghoferstrasse 6**
**D-7410 Reutlingen (DE)**

(74) Vertreter: **Friedmann, Jürgen, Dr.-Ing. et al**
**Zentralabteilung Patente,**
**Postfach 30 02 20**
**D-70442 Stuttgart (DE)**

EP 0 483 149 B1

**Beschreibung**

Stand der Technik

Die Erfindung betrifft eine Überwachungseinrichtung für eine Zündungsendstufe an einer Brennkraftmaschine gemäß dem Oberbegriff des Anspruchs 1.

Bei einer Zündungseinrichtung an einer Brennkraftmaschine werden über ein System, z.B. ein Mikrocomputersystem, in Abhängigkeit von verschiedenen Eingangsgrößen eine oder mehrere Zündungsendstufen angesteuert. Ein Problem liegt hierbei darin, daß die als Halbleiter ausgebildeten Zündungsendstufen bei zu großen Schließzeiten ungewöhnlich stark belastet werden und thermisch zerstört werden können. Solche unzulässig großen Schließzeiten können beispielsweise dann auftreten, wenn der Schließzeitpunkt kurbelwellensynchron vorgegeben wird und Fehler im Signal des entsprechenden Drehzahlgebers austreten oder große Drehzahlschwankungen etwa beim Abwürgen des Motors entstehen.

Um solchen thermischen Zerstörungen von Zündungsendstufen, die zum Ausfall der Brennkraftmaschine und Liegenbleiben eines Fahrzeugs führen, vorzubeugen, ist es einerseits bekannt, die Zündungendstufen zu überdimensionieren. Dies führt ersichtlich zu höheren Kosten von Zündungsendstufen, die nur für Störfälle so stark dimensioniert werden müssen.

Eine weitere, bekannte Maßnahme, eine thermische Zerstörung von Zündungsendstufen zu verhindern, liegt darin, in einem Überwachungssystem die Schließzeit, d.h. die Ansteuerzeit, für eine Zündungsendstufe auf eine bestimmte Zeit zu begrenzen. Dies bedeutet, daß beim Erreichen des Schließzeitpunkts ein Zeitgeber gestartet wird, der von sich aus die Zündung nach der vorgegebenen, konstanten Zeit auslöst, wenn nicht vorher der ungestörte, normale Zündvorgang ausgelöst wurde.

Die Versorgungsspannung für die Zündungsendstufe ist üblicherweise eine Batteriespannung und unterliegt je nach Ladezustand der Batterie und der Zuschaltung weiterer Verbraucher erheblichen Schwankungen. Intelligente Ansteuereinheiten berücksichtigen bereits diese Batterieschwankungen bei der Ermittlung und Berechnung der erforderlichen Schließzeiten, wobei die Schließzeiten bei höheren Batteriespannungen reduziert werden. Die bekannte Überwachungsschaltung mit einer vorgegebenen, konstanten Begrenzungszeit führt dazu, daß bei einer hohen zur Verfügung stehenden Batteriespannung trotz der Begrenzungszeit relativ viel Energie in der Endstufe vernichtet werden muß. Es ist daher erforderlich, eine solche Endstufe trotz Überwachungs- und Sicherheitsschaltung relativ stark zu dimensionieren, um auch dann eine thermische Zerstörung zu verhindern, wenn bei gerade zur Verfügung stehender hoher Betriebsspannung am Ende der Begrenzungs- und Sicherheitszeit viel Energie in der Zündendstufe vernichtet werden muß.

Vorteile der Erfindung

Mit einer Überwachungseinrichtung für eine Zündungsendstufe an einer Brennkraftmaschine nach den Merkmalen des Anspruchs 1 wird vorteilhaft erreicht, daß durch die Berücksichtigung der gerade anstehenden Versorgungsspannung bei der Begrenzungszeit ($t = f (U_{BATT})$) auch bei hohen gerade zur Verfügung stehenden Versorgungsspannungen Zündungsendstufen nicht überdimensioniert werden müssen. Die Schließzeit wird dabei auf ein Maximum (Begrenzungszeit) begrenzt, welches von der Versorgungsspannung, üblicherweise der gerade anstehenden Batteriespannung, abgeleitet ist, wodurch Zündungsendstufen nur noch für Betriebszustände ausgelegt werden müssen, wie sie beim "normalen" Fahrbetrieb vorkommen. Diese Überwachungseinrichtung bietet eine Sicherheit gegen Beschädigung und thermische Zerstörung von Zündungsendstufen sowohl bei nicht berechenbaren Betriebszuständen als auch bei Fehlern im Zündungssystem.

Diese Begrenzung der Schließzeit kann durch Soft- und/oder Hardware erfolgen.

Insgesamt können daher Zündungsendstufen kostengünstiger wegen der nicht erforderlichen Überdimensionierung ausgelegt werden. Dies gilt besonders bei ruhender Verteilung, da dort die Verlustleistung pro Zünder ca. 1 W beträgt.

Zeichnung

Zwei Ausführungsbeispiele der Erfindung sind in der Zeichnung dargestellt und werden in der nachfolgenden Beschreibung näher erläutert.
Es zeigen
Fig. 1     ein Mikrocomputersystem zur Ansteuerung einer Zündungsendstufe,
Fig. 2     ein Diagramm zur Darstellung eines Fehlers in einem Drehzahlgeber mit einer Auslösung eines Zündvorgangs über eine Überwachungseinrichtung,
Fig. 3     ein Diagramm zur Darstellung der Abhängigkeit der Begrenzungszeit von der Versorgungsspannung,
Fig. 4     ein Schaltungsdiagramm für eine Softwarelösung zur Realisierung einer Überwachungseinrichtung,
Fig. 5     eine Schaltung als Hardwarelösung und
Fig. 6     ein Diagramm, das die Signalverläufe in der Schaltung nach Fig. 5 zeigt.

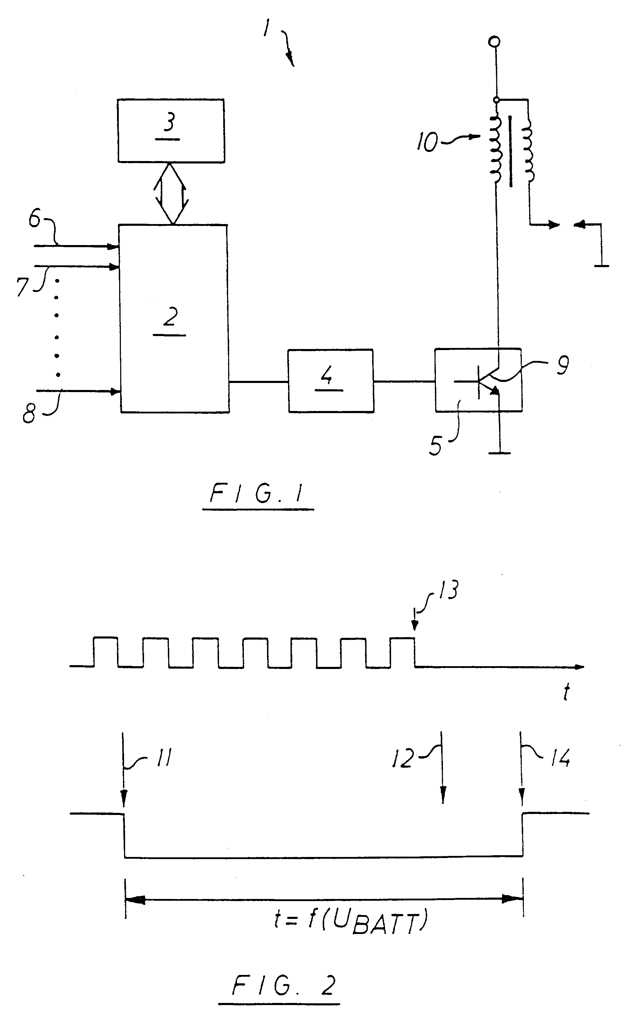

In Fig. 1 ist ein Zündungssystem 1 dargestellt, das in wesentlichen einen Mikrocomputer 2 mit korrespondierendem Speicher 3, eine dem Mikrocomputer nachgeschaltete Zündungsvorstufe 4 und eine dieser nachgeschaltete Zündungsendstufe 5 enthält.

Dem Mikrocomputer 2 werden eine Anzahl von Eingangsgrößen, insbesondere der Wert für die Batteriespannung 6, ein Kurbelwellensignal 7 und Motordaten 8 zugeführt, die alle als Einflußgrößen für den Schließzeitpunkt, die Schließzeit und die Zündzeit in Mikrocomputer 2 berücksichtigt werden.

Die Zündungsendstufe besteht im wesentlichen aus Halbleiterelementen, was schematisch durch einen Transistor 9 dargestellt ist, an den ein Zündspulensystem 10 angeschlossen ist, das über die Batteriespannung $U_{BATT}$ versorgt wird.

Im normalen Betriebsfall der Brennkraftmaschine ermittelt der Mikrocomputer 2 in Abhängigkeit seiner Eingangsgrößen sowohl den Schließzeitpunkt als auch die erforderliche Schließzeit, wonach gezündet (Sperren des Zündtransistors 9) wird.

In Fig. 2 ist im oberen Teil die Rechtecksignalfolge eines Drehzahlgebers dargestellt, der Drehzahl und Lage der Kurbelwelle darstellen soll. Darunter ist die Ansteuerkurve für die Zündungsendstufe 5 bzw. die Zündungsvorstufe 4 angegeben: Zu einem Zeitpunkt (Pfeil 11) wird der Schließzeitpunkt vom Mikrocomputer 2 ermittelt und entsprechend der Zündtransistor 9 aufgesteuert. Bei einem korrekt arbeitenden Drehzahlgeber würde der Mikrocomputer den Zündzeitpunkt nach einer Zeit entsprechend der Lage des Pfeils 12 berechnen und ausgeben.

Im Beispiel der Fig. 2 soll aber der Drehzahlgeber schon vorher (Pfeil 13) ausfallen, so daß der Mikrocomputer den Zündzeitpunkt beim Pfeil 12 nicht ermitteln kann und daher dieses Zündereignis wegen des defekten Drehzahlgebers entfällt.

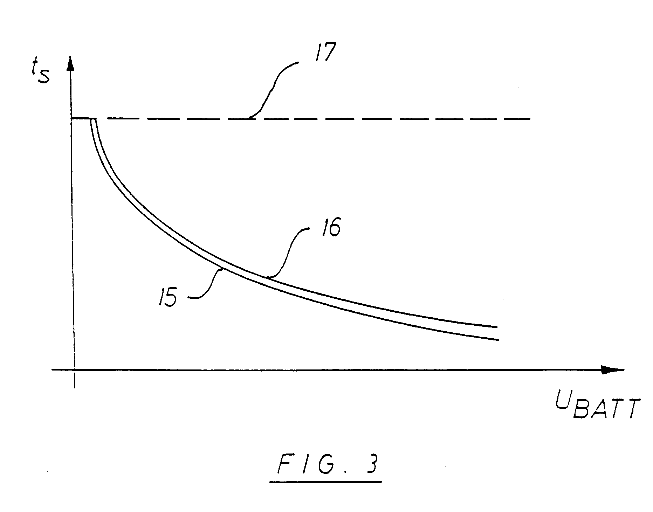

Zugleich mit der Ansteuerung der Zündungsvorstufe bzw. Zündungsendstufe (Pfeil 11) wurde ein Timer gestartet, der in Abhängigkeit der anliegenden Batteriespannung (die Abhängigkeit wird in Verbindung mit Fig. 3 näher erläutert) eine maximale Schließzeit in der Form einer Begrenzungszeit $t = f (U_{BATT})$ ausgibt und nach Ablauf dieser Begrenzungszeit (Pfeil 14) die Zündung durch Sperren des Zündtransistors auslöst. Dadurch wird eine thermische Schädigung oder Zerstörung der Zündungsendstufe 5 verhindert.

In Fig. 3 ist ein Diagramm dargestellt, in dem nach oben die Schließzeit $t_s$ und nach rechts die Batteriespannung aufgetragen sind. Die untere Kurve 15 stellt die Abhängigkeit der berechneten Schließzeit von der Versorgungsspannung bzw. Batteriespannung am Zündspulensystem dar. Es ist ohne weiteres ersichtlich, daß, wie bereits eingangs erwähnt, die Schließzeit kürzer werden kann, wenn eine größere Batteriespannung gerade zur Verfügung steht. Die Berücksichtigung der Größe der gerade zur Verfügung stehenden Batteriespannung wird beispielsweise durch den Mikrocomputer 2 durchgeführt. Üblicherweise ergibt sich dabei die in Fig. 3 dargestellte, etwa exponentielle Abnahme der berechneten Schließzeit in Abhängigkeit der zunehmenden Batteriespannung.

Die erfindungsgemäß ermittelte Begrenzungszeit berücksichtigt ebenfalls und in gleichem Maße den Einfluß der Batteriespannung, so daß die dadurch jeweils vorgegebene Begrenzungszeit über der berechneten normalen Schließzeit liegt, wie dies mit der Kurve 16 dargestellt ist. Daraus ist zu ersehen, daß die Belastung einer Zündungsendstufe auch bei Störungen, das heißt bei einer Auslösung durch die Überwachungsschaltung etwa im Bereich der üblichen Belastung im normalen Betriebszustand ist und somit keine Überdimensionierungen erforderlich sind.

Der Vollständigkeit halber ist auch als strichlierte Gerade 17 die Schließzeitbegrenzung nach dem Stand der Technik mit einer konstant festgelegten, maximalen Schließzeit eingetragen. Daraus ist zu erkennen, daß zwar die Schließzeit bei einem normalen Betriebszustand bei einer hohen Versorgungsspannung reduziert wird, bei einer Störung und einer Zündungsauslösung durch die Überwachungseinrichtung aus dem Stand der Technik eine hohe Energie in der Zündungsendstufe auftritt und vernichtet werden muß, was eine starke Dimensionierung zum Schutz gegen thermische Schäden erfordert.

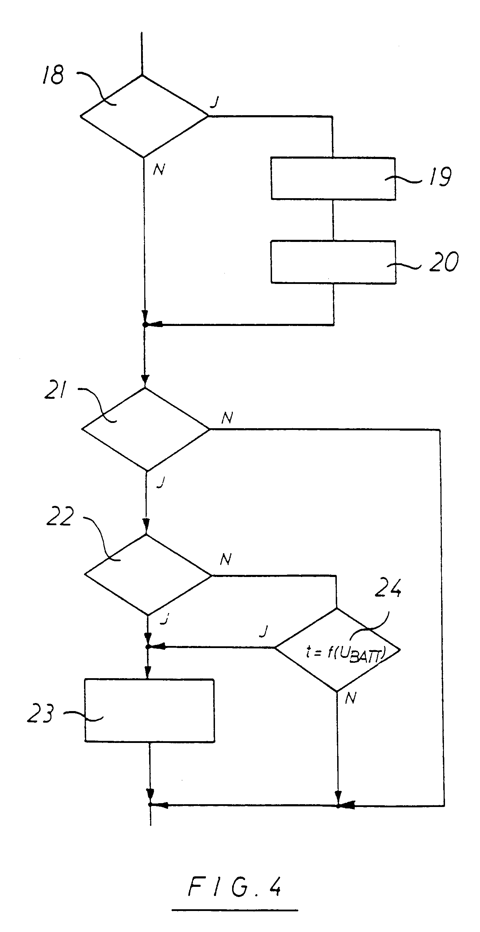

In Fig. 4 ist ein Diagramm für eine Softwarelösung angegeben, wobei diese Softwarelösung kostenneutral ist, wenn genügend Speicher- und Rechnerkapazität zur Verfügung stehen.

In einer ersten Einheit 18 wird ermittelt, ob der Schließzeitpunkt erreicht ist. Wenn ja (J), wird ein Signal zum Durchsteuern der Zündungsendstufe (Block 19) abgegeben und ein Timer gestartet (Block 20).

In einer Einheit 21 wird ermittelt, ob der Timer läuft. Wenn nicht (N), erfolgt keine Auslösung. Wenn ja (J), wird in einer Einheit 22 ermittelt, ob der erforderliche Zündwinkel erreicht wurde. Wenn ja (J), wird die Zündungsendstufe gesperrt, d.h. gezündet (Block 23).

Über eine Einheit 24 wird ermittelt, ob die in Abhängigkeit der Batteriespannung ausgegebene maximale Schließzeit bzw. Begrenzungszeit $t = f (U_{BATT})$ erreicht wurde. Ist bis dahin noch keine Zündung ausgelöst worden, wird diese durch die Einheit 24 ausgelöst. Ist die Begrenzungszeit abgelaufen, bevor der Zündwinkel erreiche ist, wird zum Schutz der Zündungsendstufe ebenfalls gezündet.

Andererseits wird die über den Timer in Lauf gesetzte Überwachungszeit beim Zünden (Sperren des Zündtransistors) wieder gestoppt.

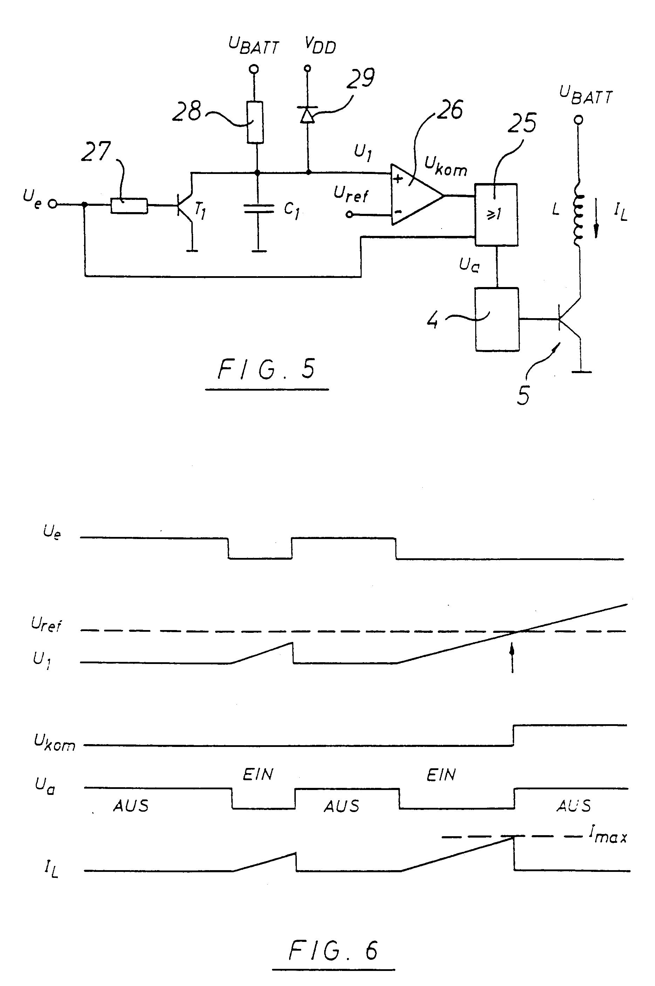

Die Fig. 5 und 6 zeigen eine weitere Ausführungsform der Erfindung. Die Schaltung nach Fig. 5 enthält wiederum eine Zündungsendstufe 5 und eine Zündungsvorstufe 4. Der Zündungsvorstufe 4 ist ein ODER-Glied 25 vorgeschaltet, das bei einer Durchsteuerung ein Signal $U_a$ abgibt.

Am ODER-Glied 25 liegt einerseits das eigentliche Ansteuersignal $U_e$ an und andererseits das Signal $U_{kom}$ des Ausgangs eines Komparators 26. Am Minus-Eingang des Komparators 26 liegt eine Referenzspannung $U_{ref}$ an und am Plus-Eingang ein zeitlich veränderliches Signal $U_1$.

Das eigentliche Ansteuersignal $U_e$ ist über einen Widerstand 27 an einen Transistor $T_1$ geführt, dem ein Kondensator $C_1$ nachgeschaltet ist. Der Kondensator $C_1$ liegt einseitig an Masse und ist mit seiner anderen Seite über einen Widerstand 28 mit der Batteriespannung $U_{BATT}$ verbunden. Weiter ist über eine Diode 29 eine Verbindung zur internen Versorgungsspannung $V_{DD}$ (bevorzugt 5 V) hergestellt, wobei an der Verbindung das Signal $U_1$ auftritt und dem Plus-Eingang des Komparators 26 zugeführt ist.

Die Funktion der Schaltung nach Fig. 5 wird im weiteren auch unter Bezug auf das Diagramm nach Fig. 6 erläutert: Das Ansteuersignal $U_e$ für die Zündungsvorstufe 25 ist im vorliegenden Beispiel 0 V, wenn der Zündtransistor leiten soll und $V_{DD}$ wenn der sperren soll. Vom Ansteuersignal $U_e$ wird der Transistor $T_1$ durchgesteuert, wenn $U_e = V_{DD}$. Über den Transistor $T_1$ wird dann der Kondensator $C_1$ entladen. Ist $U_e$ gleich 0 V sperrt der Transistor $T_1$ und der Kondensator $C_1$ wird abhängig von der Batteriespannung $U_{BATT}$ über den Widerstand 28 geladen. Überschreitet die Spannung am Kondensator $C_1$ ($U_1$) die Schwelle durch die Referenzspannung $U_{ref}$, welche einem maximalstrom $I_{max}$ entspricht, springt die Ausgangsspannung $U_{kom}$ des Komparators 26 von 0 V auf $V_{DD}$. Die Zündungsendstufe wird nur durchgesteuert, wenn $U_{kom} = U_e$ = 0 V. Es wird daher gezündet, sobald $U_1$ größer als $U_{ref}$ wird und dadurch das Signal $U_{kom}$ auf $V_{DD}$ springt. Durch die Ladungszeit des Kondensators bzw. die Anstiegszeit von $U_1$ bis $U_{ref}$ ist somit die Begrenzungszeit für die Auslösung durch die Überwachungseinrichtung bestimmt.

Bei dieser Ausführungsform wird die Zündungsendstufe selbst bei Ausfall des Mikrocomputersystems vor einer Zerstörung geschützt. Der zeitliche Verlauf des Spulenstroms wird über die Spannung am Kondensator $C_1$ nachgebildet. Damit kann indirekt eine Begrenzung des Stromes durch die Zündungsendstufe ohne direkte Messung realisiert werden.

**Patentansprüche**

1. Überwachungseinrichtung für eine Zündungsendstufe an einer Brennkraftmaschine mit einer Schließzeitbegrenzungseinrichtung für die über eine Versorgungsspannung ($U_{BATT}$) versorgte Zündungsendstufe (5), wobei die Schließzeitbegrenzungseinrichtung über ein Steuersignal bei Feststellung des Schließzeitpunkts in Lauf gesetzt wird und nach Ablauf einer Begrenzungszeit (t) für den Fall, daß bis zum Ablauf der Begrenzungszeit (t) keine Zündung ausgelöst wurde, die Zündungsendstufe (5) für eine Zündung ansteuert, dadurch gekennzeichnet, daß die Dauer der Begrenzungszeit (t = f ($U_{BATT}$)) als Funktion der Versorgungsspannung ($U_{BATT}$) variabel eingestellt wird, dergestalt, daß bei höherer Versorgungsspannung ($U_{BATT}$) die Dauer der Begrenzungszeit (t) reduziert wird.

2. Überwachungseinrichtung nach Anspruch 1, dadurch gekennzeichnet, daß die Schließzeitbegrenzungseinrichtung als Timer ausgeführt ist, der bei Feststellung des Schließzeitpunkts gestartet und beim Zünden wieder gestoppt wird.

3. Überwachungseinrichtung nach Anspruch 1 oder 2, dadurch gekennzeichnet, daß eine Schaltung zur Berechnung der Schließzeit ($t_s$, 15) vorgesehen ist, die die gerade vorliegende Versorgungsspannung ($U_{BATT}$) dergestalt berücksichtigt, daß bei höherer Versorgungsspannung ($U_{BATT}$) die Schließzeit ($t_s$, 15) reduziert wird und die entsprechende Begrenzungszeit (t, 16), die ebenfalls die Versorgungsspannung ($U_{BATT}$) berücksichtigt, nur geringfügig größer als die berechnete Schließzeit ($t_s$, 15) ist.

4. Überwachungseinrichtung nach einem der Ansprüche 1 bis 3, dadurch gekennzeichnet, daß in einer Schaltung eine Schaltungseinheit (18) zur Erkennung des erreichten Schließzeitpunkts enthalten ist, die beim Erreichen des Schließzeitpunkts ein Steuersignal einerseits zum Ansteuern der Zündungsendstufe (Block 19) und andererseits zum Start der Schließzeitbegrenzungseinrichtung bzw. des Timers (Block 20) abgibt, daß eine nachgeschaltete Schaltungseinheit (21) zur Erkennung des Timerlaufs vorgesehen ist, die bei laufendem Timer das Ansteuersignal für die Zündungsendstufe weitergibt, daß eine weiter nachgeschaltete Schaltungseinheit (22) zur Erkennung des erreichten Zündwinkels vorgesehen ist, die beim Erreichen des Zündwinkels das Ansteuersignal für die Zündungsendstufe weitergibt und die mit einer Schaltungseinheit (24) verbunden ist, wobei diese auch vor Erreichen des Zündwinkels prüft, ob die am Timer in Abhängigkeit der Versorgungsspannung ($U_{BATT}$) eingestellte Begrenzungszeit (t) abgelaufen ist und bei abgelaufener Begrenzungszeit (t) ein Ansteuersignal für die Zündungsendstufe zum Auslösen der Zündung abgibt.

5. Überwachungseinrichtung nach Anspruch 1 bis 3, dadurch gekennzeichnet, daß der zeitliche Verlauf des Spulenstroms ($I_L$) in der Zündungsendstufe (5) über die Spannung an einem Kondensator ($C_1$) nachgebildet wird, wobei die Ladezeit des Kondensators ($C_1$) von der gegenwärtigen Versorgungsspannung ($U_{BATT}$) abhängig ist und als Maß für die Dauer der Begrenzungszeit (t = f ($U_{BATT}$)) herangezogen wird.

6. Überwachungseinrichtung nach Anspruch 5, dadurch gekennzeichnet, daß in einer Schaltung ein Komparator (26) ein diesem nachgeschaltetes ODER-Glied (25) und eine diesem nachgeschaltete Zündungsvorstufe (4) enthalten sind, wobei an dem UND-Glied (25) das eigentliche Ansteuersignal ($U_e$) für die Zündungsvorstufe (4) und das Komparatorausgangssignal ($U_{kom}$) anliegen und am Komparator (26) einerseits ein konstantes Referenzsignal ($U_{ref}$) und ein zeitabhängig ansteigendes Signal ($U_1$) verglichen werden und das zeitabhängig ansteigende Signal ($U_1$) durch den Ladezustand des Kondensators ($C_1$) bestimmt ist.

**Claims**

1. Monitoring device for an ignition final stage on an internal combustion engine, having a closing time limiting device for the ignition final stage (5) which is supplied by a supply voltage ($U_{BATT}$), the closing time limiting device being put into operation by means of a control signal when the closing instant is determined and, in the case where no ignition has been initiated up to the elapsement of the limiting time (t), activating the ignition final stage (5) for an ignition after the limiting time (t) has elapsed, characterized in that the duration of the limiting time (t = f($U_{BATT}$)) is variably set as a function of the supply voltage ($U_{BATT}$) in such a way that the duration of the limiting time (t) is reduced in the case of a higher supply voltage ($U_{BATT}$).

2. Monitoring device according to Claim 1, characterized in that the closing time limiting device is embodied as a timer which is started on determination of the closing instant and is stopped again when ignition occurs.

3. Monitoring device according to Claim 1 or 2, characterized in that a circuit is provided for calculating the closing time ($t_s$, 15) which takes account of the supply voltage ($U_{BATT}$) currently present in such a way that in the case of a higher supply voltage ($U_{BATT}$), the closing time ($t_s$, 15) is reduced and the corresponding limiting time (t, 16), which likewise takes account of the supply voltage ($U_{BATT}$), is only slightly larger than the calculated closing time ($t_s$, 15).

4. Monitoring device according to one of Claims 1 to 3, characterized in that a circuit unit (18) for recognizing the closing instant reached is contained in a circuit, which circuit unit, on reaching the closing instant, emits a control signal for activating the ignition end stage (block 19) on the one hand, and for starting the closing time limiting device or the timer (block 20), on the other, in that a downstream circuit unit (21) is provided for recognizing the operation of the timer and relays the activation signal for the ignition final stage when the timer is running, in that a further downstream circuit unit (22) is provided for recognizing the ignition angle reached, which further circuit unit (22) relays the activation signal for the ignition final stage when the ignition angle is reached and which further circuit unit (22) is connected to a circuit unit (24), the latter also checking, before the ignition angle is reached, whether the limiting time (t) set at the timer as a function of the supply voltage ($U_{BATT}$) has elapsed and, if the limiting time (t) has elapsed, emitting an activation signal for the ignition final stage to initiate ignition.

5. Monitoring device according to Claims 1 to 3, characterized in that the variation with time of the coil current ($I_L$) in the ignition final stage (5) is simulated by means of the voltage at a capacitor ($C_1$), the charging time of the capacitor ($C_1$) being dependent on the then current supply voltage ($U_{BATT}$) and being used as a measure for the duration of the limiting time (t = f($U_{BATT}$)).

6. Monitoring device according to Claim 5, characterized in that a comparator (26), an OR element (25) downstream of this comparator (26) and an ignition preliminary stage (4) downstream of this OR element (25) are contained in a circuit, the actual activation signal ($U_e$) for the ignition preliminary stage (4) and the comparator output signal ($U_{kom}$) being present at the AND element (25) and a constant reference signal ($U_{ref}$) and a signal ($U_1$) rising as a function of time being compared at the comparator (26), on the one hand, and the signal ($U_1$) rising as a function of time being determined by the charge condition of the capacitor ($C_1$).

## Revendications

1. Système de surveillance pour un étage terminal d'allumage sur un moteur à combustion interne avec un dispositif de limitation du temps de fermeture pour l'étage terminal d'allumage (5) alimenté par une tension d'alimentation ($U_{BATT}$), système dans lequel le dispositif de limitation du temps de fermeture est mis en marche par l'intermédiaire d'un signal de commande lors de la détermination de l'instant de fermeture et, après l'écoulement d'un temps de limitation (t), dans le cas où jusqu'à l'écoulement de ce temps de limitation (t) aucun allumage n'a été déclenché, l'étage terminal d'allumage (5) commande l'étage terminal d'allumage (5) pour un allumage, système de surveillance caractérisé en ce que la durée du temps de limitation (t = f ($U_{BATT}$)) est réglée de façon variable en fonction de la tension d'alimentation ($U_{BATT}$), de façon que pour une tension d'alimentation ($U_{BATT}$) plus élevée, la durée du temps de limitation (t) soit réduite.

2. Système de surveillance selon la revendication 1, caractérisé en ce que le dispositif de limitation du temps de fermeture revêt la forme d'une minuterie qui est mise en route lors de la détermination de l'instant de fermeture et est à nouveau stoppée lors de l'allumage.

3. Système de surveillance selon la revendication 1 ou la revendication 2, caractérisé en ce qu'il est prévu un circuit pour le calcul du temps de fermeture ($t_s$, 15), qui tient compte de la tension d'alimentation ($U_{BATT}$) effectivement présente de sorte que, dans le cas d'une tension d'alimentation ($U_{BATT}$) plus élevée, le temps de fermeture ($t_s$, 15) est réduit et le temps de limitation correspondant (t, 16) qui tient compte également de la tension d'alimentation ($U_{BATT}$) n'est que légèrement supérieur au temps de fermeture calculé ($t_s$, 15).

4. Système de surveillance selon l'une des revendications 1 à 3, caractérisé en ce que dans un circuit est comprise une unité de commutation (18) pour détecter que l'instant de fermeture est atteint, cette unité lorsque l'instant de fermeture est atteint, délivre un signal de commande d'une part pour commander l'étage terminal d'allumage (bloc 19) et d'autre part pour mettre en route le dispositif de limitation du temps de fermeture ou bien la minuterie (bloc 20), en ce qu'il est prévu une unité de commutation (21) branchée à la suite pour détecter la marche de la minuterie et qui, dans le cas où la minuterie est en marche, retransmet le signal de commande pour l'étage terminal d'allumage, en ce qu'il est prévu une autre unité (22) branchée à la suite pour détecter l'angle d'allumage atteint et qui, lorsque l'angle d'allumage est atteint retransmet le signal de commande pour l'étage terminal d'allumage et est reliée à une unité de commutation (24), celle-ci vérifiant également, avant que l'angle d'allumage soit atteint, si le temps de limitation (t) réglé sur la minuterie en fonction de la tension d'alimentation ($U_{BATT}$) est écoulé et, si ce temps de limitation (t) est écoulé, délivre un signal de commande pour l'étage terminal d'allumage fin de déclencher l'allumage.

5. Système de surveillance selon l'une des revendications 1 à 3, caractérisé en ce que l'évolution dans le temps du courant de bobine ($I_L$) dans l'étage terminal d'allumage (5) est représentée par l'intermédiaire de la tension sur un condensateur ($C_1$), le temps de charge de ce condensateur ($C_1$) dépendant de la tension d'alimentation actuelle ($U_{BATT}$) et étant utilisé en tant que mesure de la durée du temps de limitation (t = f ($U_{BATT}$)).

6. Système de surveillance selon la revendication 5, caractérisé en ce que dans un circuit sont compris un comparateur (26), une porte OU (25) branchée à la suite de ce comparateur, et un étage préliminaire d'allumage (4) branché à la suite de cette porte, tandis qu'à cette porte OU (25) s'applique le signal de commande proprement dit ($U_e$) pour l'étage préliminaire d'allumage (4) et le signal de sortie ($U_{kom}$) du comparateur, tandis qu'au comparateur (26) sont comparés d'une part un signal de référence constant ($U_{ref}$) et un signal ($U_1$) augmentant en fonction du temps, et ce signal ($U_1$) augmentant en fonction du temps est déterminé par l'état de charge du condensateur ($C_1$).

$$F \, I \, G . \, 1$$

$$t = f(U_{BATT})$$

$$F \, I \, G . \, 2$$

FIG. 3

$$F I G . 4$$

$F I G . 5$

$F I G . 6$